# EUROPEAN PATENT APPLICATION

(11) **EP 2 242 085 A1**
(43) Date of publication of application: **20.10.2010**
(21) Application number: 09815445.3
(22) Date of filing: 12.11.2009
(51) Int. Cl.: H01J 9/02, G03F 9/00, H01J 11/02

(54) **FLAT PANEL DISPLAY MANUFACTURING METHOD**

(30) Priority: 14.11.2008 JP 2008292248; 14.11.2008 JP 2008292249; 14.11.2008 JP 2008292250
(71) Applicant: Panasonic Corporation, Kadoma-shi Osaka 571-8501 (JP)
(72) Inventor: URIU, Eiichi, Osaka-shi, Osaka 540-6207 (JP); TANIGUCHI, Motohiro, Osaka-shi, Osaka 540-6207 (JP); MURAKOSO, Tomohiro, Osaka-shi, Osaka 540-6207 (JP); OTANI, Toshiya, Osaka-shi, Osaka 540-6207 (JP); YAMAMOTO, Souji, Osaka-shi, Osaka 540-6207 (JP); FUJIWARA, Toshiaki, Osaka-shi, Osaka 540-6207 (JP); SESEI, Takashi, Osaka-shi, Osaka 540-6207 (JP); MATSUBARA, Noriyuki, Osaka-shi, Osaka 540-6207 (JP)
(74) Representative: Kügele, Bernhard
(86) International application number: PCT/JP2009/006035
(87) International publication number: WO 2010/055660

(57) **Abstract**

An alignment mark having high precision and good visibility is formed in a simple manner without modification of a manufacturing line or a significant increase of man hours and a flat panel display is manufactured at low cost and with good productivity. To achieve this, the method includes a step of forming a photosensitive film on a substrate, a step of forming an alignment mark (51) by exposing the photosensitive film by using an exposing mask (41), and a step of performing position alignment by recognizing the alignment mark (51) in an undeveloped state of the photosensitive film.

## Description

### TECHNICAL FIELD

The present invention relates to a method of manufacturing a flat panel display such as a plasma display panel.

### BACKGROUND ART

In recent years, among flat panel displays, a plasma display panel (hereinafter, referred to as "PDP") which is easy to make a larger size has become widely used.

In a conventional PDP, a large number of discharge cells are formed between a front panel and a back panel facing each other. The front panel includes a glass substrate on the front side, one pair of display electrodes composed of a scan electrode and a sustain electrode, and a dielectric layer and a protective layer which cover the electrodes. The back panel includes a glass substrate on the back side, data electrodes formed on the glass substrate, a dielectric layer covering them, barrier ribs, and phosphor layers. The front panel and the back panel are placed to face each other such that the display electrode pairs and the data electrodes cross each other in a grade separated manner and is sealed, and a discharge gas is charged into and sealed in a discharge space inside thereof. Here, a discharge cell is formed at a position at which the display electrode pair and the data electrode face each other. In the discharge cell of the PDP having the structure, a gas discharge is performed and red, green, and blue phosphors are excited. Thus the phosphors emit light and a color display is performed.

The scan and sustain electrodes take a form in which a bus electrode having a narrow stripe shape is stacked on a transparent electrode having a broad stripe shape. The transparent electrode is formed by patterning an indium tin oxide (hereinafter, referred to as "ITO") thin film, which is formed on the entire surface of the glass substrate by a sputtering method, with a photolithography method into the striped shape. Alignment marks for aligning positions of exposing masks which are used in a subsequent process (step) are also simultaneously formed during the patterning. The bus electrodes are formed by printing a conductive photosensitive paste on the glass substrate on which the transparent electrodes and the alignment marks are formed, then exposing the printed paste after position alignment, and finally etching the printed paste (see patent document 1).

However, a vacuum apparatus, which has a large size, and an ITO target material, which is expensive, are needed to form the ITO thin film by a sputtering method when forming the transparent electrodes. Furthermore, an exposing apparatus and an exposing mask are also needed to pattern the ITO thin film. That is, there is a problem in that not only is the manufacturing equipment large but also the productivity of the PDP is low.

For such a reason, a PDP manufactured by a method in which the scan electrodes and the sustain electrodes are formed with the conductive bus electrodes instead of the transparent electrodes is disclosed (for example, see patent document 2). However, the PDP without the transparent electrodes also has another problem such that the alignment marks must be formed in another way. As the method of forming the alignment marks, there are known examples. One is a method of forming the alignment marks by a printing method or a laser marking method (for example, see patent document 3). Another is a method of forming the alignment marks with the same material as the bus electrodes.

Position precision, shape precision, and visibility are important for the alignment marks of the flat panel display. In a high precision PDP which has been widely used in recent years, very high position and shape precision is especially required. However, in the case of manufacturing the PDP having an electrode structure and no transparent electrodes, there are problems such that the alignment marks must be formed in a different way, the manufacturing line must be modified, and the manufacturing man-hours increase.

For example, a method of forming the alignment marks using the conventional photosensitive paste is also disclosed, but the method also has a problem with a significant increase of manufacturing man-hours because the exposing and developing processes must be additionally incorporated in the previous stage of formation of the display electrode pairs.

Further, the alignment marks and the display electrode pairs can be simultaneously formed upon forming the display electrode pairs using the conventional conductive photosensitive paste. However, in the case of forming the display electrode pairs through a number of exposures, such methods cannot be used. In practice, when forming the display electrode pairs, two exposures are performed to suppress scratches on and dust adhesion to the exposing mask. In this case, as a minimum, an alignment mark for position alignment with an exposing mask for the second exposure is essential to prevent misalignment between a first exposure and a second exposure.

The invention is conceived in view of the above problems, and provides a manufacturing method of a flat panel display by which it is possible to simply form alignment marks having high precision and good visibility without modification of a manufacturing line or an increase in man hours and by which it is possible to manufacture a flat panel display at low cost and with high productivity.

### Patent Literature

Patent Literature 1 Japanese Patent Application Unexamined Publication No.2000-156158
Patent Literature 2 Japanese Patent Application Unexamined Publication No.2004-127951
Patent Literature 3 Japanese Patent Application Unexamined Publication No.2004-130789

### SUMMARY OF THE INVENTION

A manufacturing method of the flat panel display of the invention includes a step of forming a photosensitive film on a substrate, a step of forming an alignment mark by exposing the photosensitive film, and a step of detecting a position of the substrate by recognizing the alignment mark in the state in which the photosensitive film is not yet developed.

According to the method, it is possible to simply form an alignment mark having high precision and good visibility without modification of a manufacturing line or an increase of man hours and to manufacture a flat panel display at low cost and with high productivity.

### BRIEF DESCRIPTION OF DRAWINGS

Fig. 1 is an exploded perspective view of a PDP according to embodiment 1 of the invention.
Fig. 2A is a view showing details of a front panel of the PDP.
Fig. 2B is a view showing details of a front panel of the PDP.
Fig. 3A is a view for explaining a manufacturing method of the front panel of the PDP.
Fig. 3B is a view for explaining a manufacturing method of the front panel of the PDP.
Fig. 3C is a view for explaining a manufacturing method of the front panel of the PDP.
Fig. 3D is a view for explaining a manufacturing method of the front panel of the PDP.
Fig. 3E is a view for explaining a manufacturing method of the front panel of the PDP.
Fig. 3F is a view for explaining a manufacturing method of the front panel of the PDP.
Fig. 3G is a view for explaining a manufacturing method of the front panel of the PDP.
Fig. 3H is a view for explaining a manufacturing method of the front panel of the PDP.
Fig. 4A is a view showing an alignment mark of the PDP.
Fig. 4B is a view showing an alignment mark of the PDP.
Fig. 5A is a view showing details of an alignment mark of the PDP.
Fig. 5B is a view showing details of an alignment mark of the PDP.
Fig. 5C is a view showing details of an alignment mark of the PDP.
Fig. 6A is a view for explaining a manufacturing method of a back panel of the PDP.
Fig. 6B is a view for explaining a manufacturing method of a back panel of the PDP.
Fig. 6C is a view for explaining a manufacturing method of a back panel of the PDP.
Fig. 6D is a view for explaining a manufacturing method of a back panel of the PDP.
Fig. 6E is a view for explaining a manufacturing method of a back panel of the PDP.
Fig. 7A is a view for explaining a manufacturing method of a front panel of a PDP according to embodiment 2 of the invention.
Fig. 7B is a view for explaining a manufacturing method of the front panel of the PDP.
Fig. 7C is a view for explaining a manufacturing method of the front panel of the PDP.
Fig. 7D is a view for explaining a manufacturing method of the front panel of the PDP.
Fig. 7E is a view for explaining a manufacturing method of the front panel of the PDP.
Fig. 7F is a view for explaining a manufacturing method of the front panel of the PDP.
Fig. 7G is a view for explaining a manufacturing method of the front panel of the PDP.
Fig. 7H is a view for explaining a manufacturing method of the front panel of the PDP.
Fig. 7I is a view for explaining a manufacturing method of the front panel of the PDP.
Fig. 8 is a view showing details of a display electrode pair having a different shape from that of the PDPs of embodiment 1 and embodiment 2.
Fig. 9A is a view showing details of an alignment mark having a different shape from that of the PDPs of embodiment 1 and embodiment 2.
Fig. 9B is a view showing details of an alignment mark which has a different shape from that of the PDP.
Fig. 9C is a view showing details of an alignment mark having another different shape from that of the PDP.

### DETAILED DESCRIPTION OF PREFERRED EMBODIMENTS

Hereinafter, a manufacturing method of a flat panel display according to the embodiment of the invention will be described with reference to the drawings, exemplifying a manufacturing method of a PDP.

### Embodiment 1

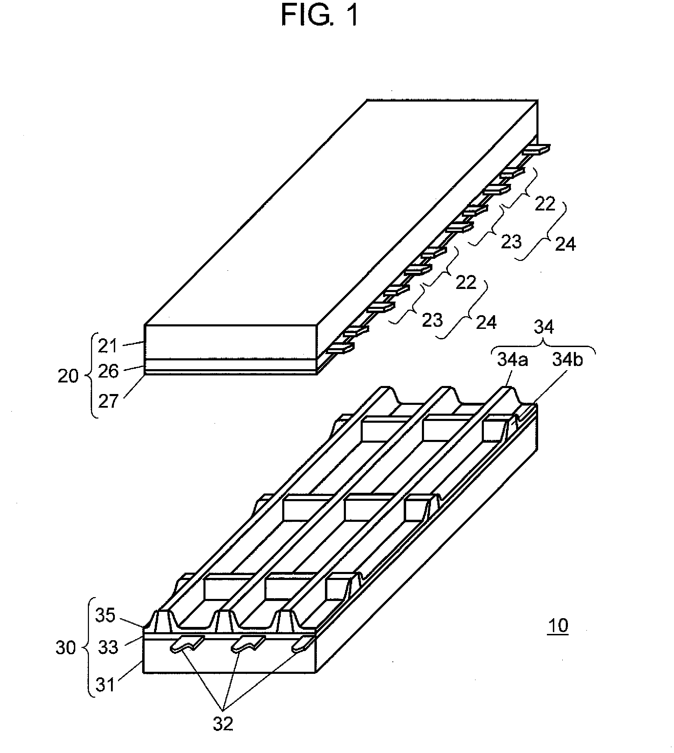

Fig. 1 is an exploded perspective view showing PDP 10 according to embodiment 1 of the invention. PDP 10 is structured such that front panel 20 and back panel 30 are placed face to face and sealed to each other with low melting point glass (not shown) at peripheral portions thereof and a plurality of discharge cells is formed inside thereof.

Back panel 30 includes glass substrate 31 on the back side, data electrodes 32, dielectric layer 33, barrier ribs 34, and phosphor layers 35. A plurality of data electrodes 32 is formed in parallel on glass substrate 31. Dielectric layer 33 is formed so as to cover the data electrodes 32. Barrier ribs 34 composed of longitudinal barrier ribs 34a and lateral barrel ribs 34b are formed on dielectric layer 33 in a grid-like form. Red, green, and blue phosphor layers 35 are formed on the surface of dielectric layer 33 and the side walls of barrier ribs 34.

Front panel 20 and back panel 30 are placed to face each other such that display electrode pairs 24 and data electrodes 32 grade-separated cross each other. Discharge cells are formed at a place where display electrode pairs 24 and data electrode 32 face each other. Front panel 20 and back panel 30 are sealed to each other with low melting point glass at a position outside an image display region in which the discharge cells are formed, and a discharge space on the inner side is charged with a discharge gas.

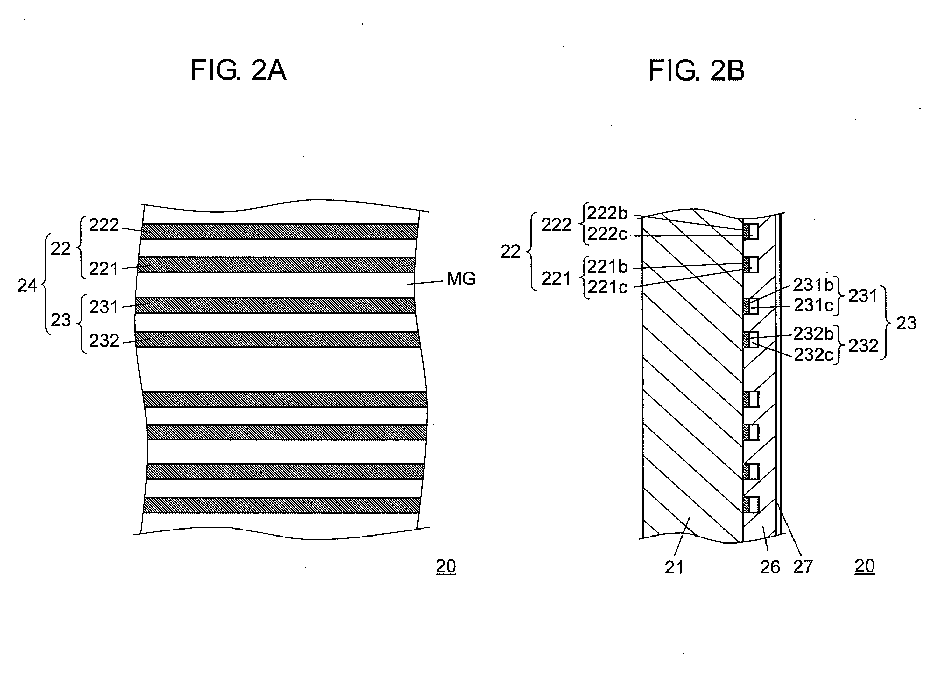

Fig. 2A and Fig. 2B are views showing details of front panel 20 of PDP 10 according to embodiment 1 of the invention. Fig. 2A is an enlarged view showing the front side of front panel 20 and Fig. 2B is an enlarged view showing the cross-section of front panel 20.

Scan electrode 22 includes bus electrode 221 and bus electrode 222. Sustain electrode 23 also includes bus electrode 231 and bus electrode 232. Discharge gap MG is formed between bus electrodes 221 and bus electrodes 231.

Each of bus electrodes 221 and 222 is composed of black layer 221b, 222b and conductive layer 221c, 222c, and each of bus electrodes 231 and 232 is composed of black layer 231b, 232b and conductive layer 231c, 232c. Black layers 221b, 222b, 231b, and 232b are provided in order to make scan electrodes 22 and sustain electrodes 23 look black when they are viewed from the displaying surface side of PDP 10. For example, a black material such as ruthenium oxide is formed on glass substrate 21 in a stripe form having a small width. Conductive layers 221c, 222c, 231c, and 232c are formed in order to increase conductivity of scan electrodes 22 and sustain electrodes 23, and formed by stacking a conductive material containing silver on black layers 221b, 222b, 231b, and 232b.

In the embodiment, as various pastes used to specifically manufacture front panel 20, a photosensitive paste of a black color (hereinafter, referred to as "black photosensitive paste"), a photosensitive paste having conductivity (hereinafter, referred to as "conductive photosensitive paste"), and a dielectric paste are used. A method of preparing the pastes is described below.

### Black photosensitive paste

The black photosensitive paste is a photosensitive paste provided in order to form black layers 221b, 222b, 231b, and 232b and the alignment marks. The black photosensitive paste is formed by forming a first photosensitive film (hereinafter, referred to as "black photosensitive film") by coating a paste on glass substrate 21 and then drying it, and exposing the first photosensitive film. The black photosensitive paste is composed of an inorganic component containing a black color material and glass powder as solid content and an organic material component containing a photosensitive polymer, a photosensitive monomer, and a photo polymerization initiator. The particle size of the black color material is 1 µm or smaller.

The black photosensitive paste is prepared by blending an inorganic material composed of a black color material and glass powder, a photosensitive polymer such as photo-curable polymer, a photosensitive monomer, and various organic materials such as a photo polymerization initiator and a solvent so as to be a predetermined composition, and uniformly mixing and dispersing the mixture.

As the black material, at least one oxide selected from the group consisting of ruthenium oxide, ferric oxide, cobalt oxide, nickel oxide, copper oxide, and manganese dioxide can be used. The average particle size of the black pigment may be preferably set to 1 µm or smaller, and more preferably to the range of 0.01 to 0.5 µm in order to increase the precision of the alignment marks. By incorporating 5 to 40% by weight of the black color material into the paste, it is possible to form good black layers 221b, 222b, 231b, and 232b, and alignment marks. If the content of the black material is less than 5% by weight, the color becomes thinner and therefore there is a possibility that the contrast will deteriorate. Conversely, if the content of the black material is greater than 40% by weight, a softening point of the paste becomes higher and it is difficult to harmonize the thermal expansion coefficient with glass substrate 21. Furthermore, it is not desirable because there is a possibility that the UV rays cannot reach the bottom portion when the exposure is performed and thus formation failure of the black layer occurs.

As the glass powder, glass powder whose main component is bismuth oxide can be used. The average particle size of the glass powder is preferably 0.3 to 100 µm. If the average particle size of glass powder is greater than 1.0 µm, it influences the surface roughness of the black photosensitive film bx, resulting in deterioration of the recognition precision of the alignment marks as described above. On the other hand, if the average particle size of the glass powder is less than 0.3 µm, there is a likelihood that agglomeration of the glass powder will occur, resulting in an increase of the particle size of the agglomerates. That is, the surface roughness of the black photosensitive film bx is affected by the average particle size and therefore the recognition precision of the alignment marks deteriorates. Further, the maximum particle size may be preferably 2.0 µm or smaller. The composition of the glass powder preferably includes 30 to 85% by weight of oxide bismuth, 5 to 30% by weight of silicon oxide, 5 to 20% of boron oxide, 0.1 to 10% by weight of zirconium oxide, 2 to 20% by weight of zinc oxide, and 1 to 5% by weight of aluminum oxide. The content of the glass powder in the paste is preferably 25 to 40% by weight to enhance adhesion to the glass substrate.

Regarding the inorganic material for the black photosensitive paste, a conductive material may be preferably contained therein. As the conductive material, metal particulates, having an average particle size of preferably 1 µm or less and more preferably 0.01 to 0.5 µm, for example, silver, platinum, palladium, cobalt, nickel, manganese, molybdenum and ruthenium can be used.

As the organic material for the black photosensitive paste, as the photosensitive polymer, an oligomer or a polymer having a weight average molecular weight of 500 to 100000, containing a carboxyl group, and an unsaturated double bonding structure is preferably used. As the photosensitive monomer, a compound having a carbon-carbon unsaturated bonding structure can be used. By setting the content of the organic material components to 20 to 60% by weight, it is possible to prepare the black photosensitive paste having a good printing characteristic. As the organic material, additional additives such as a binder, an ultraviolet (UV) absorbing agent, a sensitizer, a sensitization aid, a polymerization inhibitor, a plasticizer, a thickener, an organic solvent, an antioxidant, a dispersant, a precipitation inhibitor, and a leveling agent may be added besides the photosensitive polymer, the photosensitive monomer, the photo polymerization initiator, and the solvent if needed.

The viscosity of the black photosensitive paste is preferably in the range of 2000 to 20000 cps. For example, the viscosity is preferably 50000 to 200000 cps in order to obtain the black photosensitive film having a thickness of 5 to 20 µm by a single coating of the paste by a screen printing method. When obtaining the black photosensitive film with a blade coating method or a die coater method, it is preferably 1500 to 20000 cps. The viscosity of the black photosensitive paste can be adjusted so as to fall into the range at the addition ratio of the inorganic powder, thickener, organic solvent, plasticizer, and precipitation inhibitor.

In the embodiment, in the composition, the content of ruthenium oxide having an average particle size of 0.1 µm and serving as the black material is 10% by weight, the content of cobalt tetroxide is 26% by weight, the content of commercially available glass frit containing bismuth oxide as glass powder is 12% by weight, the total content of organic materials including commercially available photo-curable polymer, photosensitive monomer, and polymerization initiator is 22% by weight, and the content of the solvent is 30% by weight. These components are uniformly mixed with three rollers and dispersed in order to prepare the black photosensitive paste.

### Conductive photosensitive paste

The conductive photosensitive paste is a material for forming conductive layers 221c, 222c, 231c, and 232c. It is coated on the black photosensitive film and dried to form a second photosensitive film (hereinafter, referred to as "conductive photosensitive film"), and then the second photosensitive film is exposed to form the conductive layers. The conductive photosensitive paste is prepared by blending an inorganic material component composed of a conductive material whose main component is silver and glass powder, and an organic material component composed of a photosensitive polymer such as a photo-curable polymer, a photosensitive monomer, a photo polymerization initiator, and a solvent to become a predetermined composition, and then uniformly mixing and dispersing the mixture.

As the conductive material, silver powder having an average particle size of 0.1 to 2.0 µm is preferably used to finely form conductive layers 221c, 222c, 231c, and 232c. By having 45% by weight or more of silver powder contained in the paste, it is possible to form a pattern for desirable conductive layers.

As the glass powder, glass powder whose main component is bismuth oxide can be used. The average particle size of the glass powder is preferably 0.3 to 1.0 0 µm, and more preferably the maximum particle size is 2.0 µm or smaller. The composition of the glass powder preferably includes 30 to 85% by weight of bismuth oxide, 5 to 30% by weight of silicon oxide, 5 to 20% by weight of boron oxide, 0.1 to 10% by weight of zirconium oxide, 2 to 20% by weight of zinc oxide, and 1 to 5% by weight of aluminum oxide. Further, the paste preferably contains 0. 5 to 5% by weight of glass powder to enhance adhesion to the glass substrate. By setting the content of the various organic materials to 20 to 45% by weight, it is possible to form the conductive photosensitive paste having a good printing characteristic.

In the embodiment, the conductive photosensitive paste is prepared by uniformly mixing and dispersing by the three rollers the combination of 69% by weight of silver powder having an average particle size of 0.8 µm, 3% by weight of glass frit which is commercially available and whose main component is bismuth oxide, 13% by weight of a mixture of a commercially available photo-curable polymer, a photosensitive monomer, and a photo polymerization initiator, and 15% by weight of a solvent with 3 rollers.

### Dielectric paste

The dielectric paste is a material for forming the dielectric layer 26. The dielectric paste is a paste containing dielectric glass having a softening point of 520 to 590°C and containing one or more substances selected from the group consisting of boron oxide, silicon oxide, zinc oxide, alkaline earth oxide, alkaline metal oxide, bismuth oxide, aluminum oxide, molybdenum oxide, tungsten oxide, and cerium oxide.

For the dielectric layer 26 of the embodiment, a dielectric paste including dielectric glass containing 35% by weight of boron oxide, 1.4% by weight of silicon oxide, 27.2% by weight of zinc oxide, 3.3% by weight of barium oxide, 25% by weight of bismuth oxide, 1.1% by weight of aluminum oxide, 4.0% by weight of molybdenum oxide, and 3.0% by weight of tungsten oxide is prepared. The softening point of the dielectric glass prepared in the above way is 570°C.

A manufacturing method of PDP 10 will be described below.

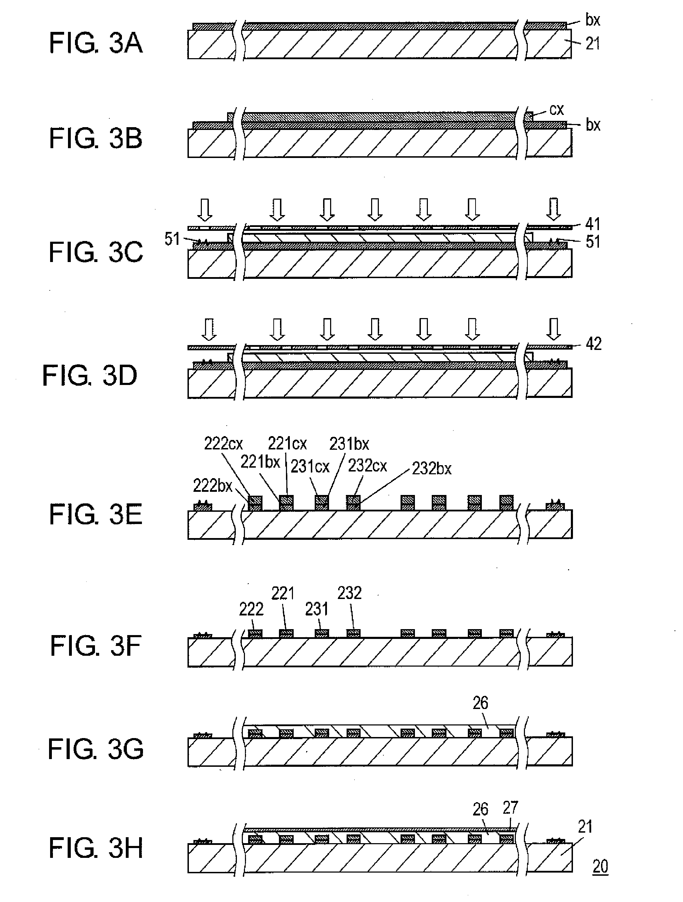

Figs. 3A, 3B, 3C, 3D, 3E, 3F, 3G, and 3H are views for explaining a manufacturing method of front panel 20 of PDP 10 according to embodiment 1 of the invention. Manufacturing processing of front panel 20 is divided into 5 steps and each of the steps will be described in detail.

### First step

In a first step, as a substrate, a glass substrate 21 is used for the front side substrate. A black photosensitive film bx serving as a first photosensitive film is formed by coating a black photosensitive paste on glass substrate 21 and drying it. Glass substrate 21 is cleaned with an alkali. Glass substrate 21 may be a glass substrate having a size of 980 mmx554 mm and a thickness of 1.8 mm in the case of a 42" PDP.

Next, as shown in Fig. 3A, a black photosensitive paste is coated and dried on the entire surface of glass substrate 21 by a known technique such as a screen printing method, forming the black photosensitive film bx. In this instance, the black photosensitive paste is coated at a region of glass substrate 21, at which display electrode pairs 24 are not supposed to be formed and alignment marks are supposed to be formed. In the embodiment, that is, the regions correspond to four corner areas of glass substrate 21. However, the regions to form the alignment marks thereon are not limited thereto. That is, they may be in regions along longer sides of glass substrate 21, at which display electrode pairs 24 are not supposed to be formed, or regions along shorter sides of glass substrate 21, at which display electrode pairs 24 are not supposed to be formed.

Next, as shown in Fig. 3B, a conductive photosensitive film cx serving as the second photosensitive film is formed on the black photosensitive film bx at a region at which the alignment marks are not supposed to be formed. The conductive photosensitive film cx is formed by coating the conductive photosensitive paste on the black photosensitive film bx of glass substrate 21 by a known technique such as a screen printing method, and drying it. In this instance, the conductive photosensitive paste is not coated at regions on the black photosensitive film bx, at which the display electrode pairs are not supposed to be formed but the alignment marks are supposed to be formed. In the embodiment, these regions correspond to four corner areas of glass substrate 21.

### Second step

In a second step, the alignment marks are formed by exposing the black photosensitive film bx with a first exposing mask. First exposing mask 41 is provided with a pattern for bus electrodes 221, 222, 231, and 232 and a pattern for alignment marks 51.

As shown in Fig. 3C, a first exposure is performed using first exposing mask 41. For this instance, the exposing intensity is, for example, 300 mJ/cm². By doing so, the concave and convex patterns appear on the surface of the black photosensitive film bx, and these form alignment marks 51. In the way described above, alignment marks 51 are formed on the black photosensitive film bx applied at four corner areas of glass substrate 21 and scan electrodes 22 and sustain electrodes 23 are formed at the image display area of glass substrate 21 by a first exposure. However, alignment marks 51 are present as the concave and convex pattern appearing on the black photosensitive film bx because the black photosensitive film bx is not yet developed.

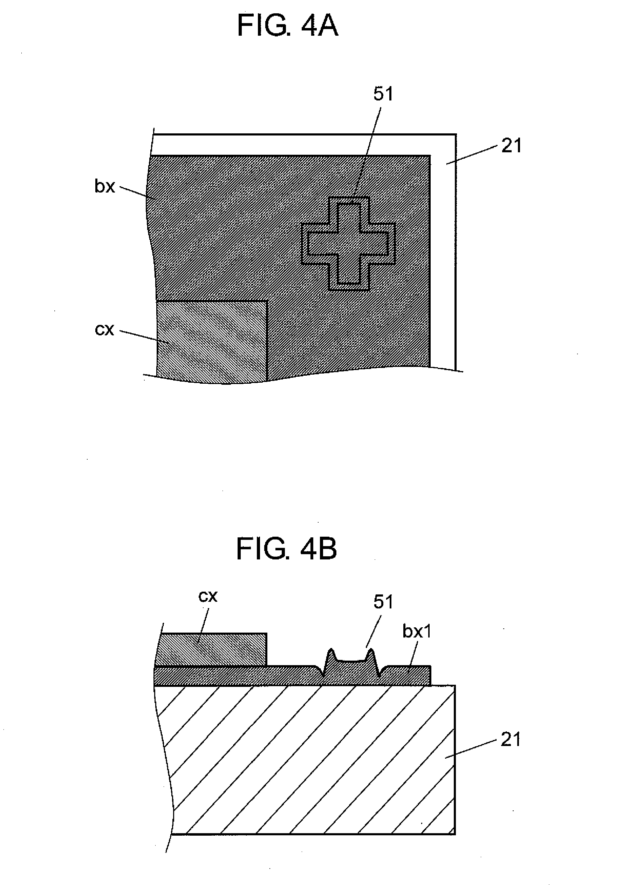

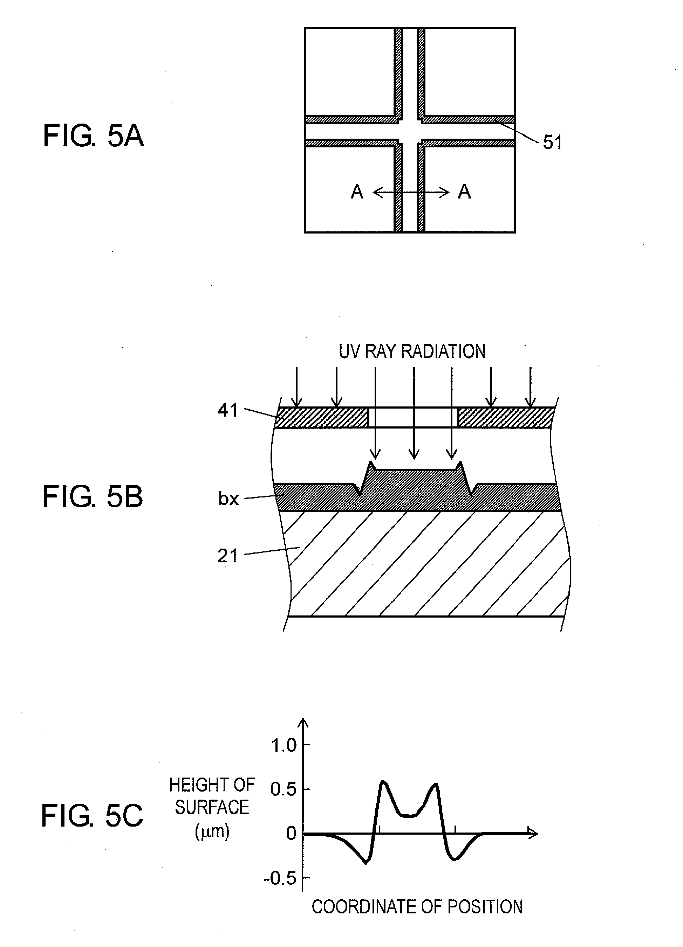

Figs. 4A and 4B are views showing alignment marks 51 of PDP 10 according to embodiment 1 of the invention. Fig. 4A is an enlarged schematic plan view of a portion of glass substrate 21 at which alignment marks 51 are formed. Fig. 4B is an enlarged sectional view of a portion of glass substrate 21 at which alignment marks 51 are formed. Figs. 5A, 5B, and 5C are views showing details of alignment marks 51 of PDP 10 according to embodiment 1 of the invention. Fig. 5A is a schematic view showing an image of alignment marks 51 taken by a camera. Fig. 5B is a view showing a relationship between first photosensitive mask 41 and alignment marks 51 of glass substrate 21. Fig. 5C is a view showing the result when the profile of the surface is measured by a surface roughness meter along line A-A.

As described above, alignment marks 51 are formed by forming the black photosensitive film bx by coating the black photosensitive paste on glass substrate 21 and then drying it, and providing at least either the convexity or the concavity to the surface of the black photosensitive film bx.

In the embodiment, as shown in Fig. 5C, alignment marks 51 are formed by the convexity and concavity in which the convex and concave portions are provided so as to be adjacent to each other on the surface of the black photosensitive film bx, and the convexity and concavity are formed by exposure. The shape of alignment marks 51 is, for example, a cross-like protrusion which is 3 mm, for example, in each of the longitudinal and lateral sizes and 160 µm in its width. It is believed that the convex portion is formed due to volume expansion occurring at the exposed region because the photosensitive monomer, which is contained in the black photosensitive film bx, at the exposed region is polymerized and thus cured by the exposure. It is believed that the concave portions and convex portions adjacent to each other at the border of the exposed region and the unexposed region are formed due to the following reason. In the exposed region, the photosensitive monomer is polymerized and cured by the exposure so that the concentration of the liquid phase monomer becomes lower. For this reason, a large concentration gradient of the liquid phase monomer is caused at the border of the unexposed region and the exposed region. Therefore, the liquid phase monomer diffuses into the exposed region from the unexposed region. The volume decreases on the unexposed region side near the border area due to the diffusion and the concave portion is formed. On the other hand, the exposed region side is swelled by the diffused liquid phase monomer and thus the convex portion is formed. In this manner, the convex portion is formed on the exposed region side of the border of the unexposed region and the exposed region, and the concave portion is formed on the unexposed region side, so that alignment marks 51 that can be optically detected are formed on the surface of the black photosensitive film bx.

There is a tendency for the degree of the concavity and convexity of the surface of the black photosensitive film bx to be relatively small right after the exposure and to become larger as time passes. For this reason, in the embodiment, 30 to 60 minutes of leaving time is provided after the first exposure.

The profile of the surface near alignment marks 51 in 60 minutes after the exposing is measured by the surface roughness meter by the inventors. As a result, as shown in Fig. 5C, the amplitude (=the maximum value - the minimum value) of the difference between the convexity and the concavity at the border of the exposed region and the unexposed region is 0.5 to 1.0 µm, so that it is certified that it can be used as the alignment marks.

Although there is likelihood that only the convex portion or only the concave portion will be formed according to the degree of the diffusion and swelling, it can be recognized as the alignment marks if the amplitude of the difference reaches the above-mentioned degree.

When light is irradiated on the alignment marks, the contrast is generated to the reflected light according to the presence of the convex portion or the concave portion and imaged by a camera. Accordingly, it may be considered that a figure can be detected.

In addition to the above, the factor that the volume decreases by drying and the difference is created at the border between the unexposed region and the exposed region can be considered. In practice, it is possible to form the alignment marks in a short time by drying the glass substrate after the exposure.

### Third step

In a third step, as shown in Fig. 3D, position alignment of second exposing mask 42 for forming scan electrode 22 and sustain electrode 23 is performed in the undeveloped state of the black photosensitive film bx by recognizing alignment marks 51 and a second exposure of the black photosensitive film bx is performed. At this time, alignment mark 51 formed on the surface of the black photosensitive film bx is irradiated with light, and position determination of the second exposing mask is performed by taking a picture of alignment mark 51 with a camera. Second exposing mask 42 is provided with a pattern for forming bus electrodes 221, 222, 231, and 232. The pattern provided in second exposing mask 42 is designed so as to have a slightly smaller width than that of the pattern of first exposing mask 41. In the embodiment, the pattern having a width smaller than that of the pattern of bus electrodes 221, 222, 231, and 232 formed in first exposing mask 41 by about 20% is formed in second exposing mask 42. In this instance, if the light irradiating on alignment mark 51 significantly diffuses, alignment mark 51 cannot be imaged with good precision. Accordingly, alignment mark 51 is irradiated with a linear light beam by a coaxial epi-illumination, and alignment mark 51 is preferably recognized by imaging the contrasting density of the reflected light. In the case in which the amplitude of the difference is less than 0.5 µm, there are some cases in which the alignment mark cannot be sufficiently recognized even when using the coaxial epi-illumination. The exposure intensity of the second exposure is, for example, about 200 mJ/cm².

By repeating the exposure for forming bus electrodes 221, 222, 231, and 232 two times, it is possible to suppress the exposure failure attributable to scratches on or dust adhesion to exposing masks 41 and 42 substantially to zero. To prevent exposing misalignment between the first exposure and the second exposure, position alignment for second exposing mask 42 is performed by using the alignment mark formed during the first exposure. Furthermore, since the electrode pattern of second exposing mask 42 is designed so as to have a slightly smaller width than that of the electrode pattern of first exposing mask 41, although slight positioning misalignment occurs, a case in which the form of the formed electrode is significantly impaired does not occur.

### Fourth step

In a fourth step, scan electrodes 22 and sustain electrodes 23 are formed by developing the black photosensitive film bx. Specifically, as shown in Fig. 3E, precursors 221bx, 222bx, 231bx, and 232bx of black layers 221b, 222b, 231b, and 232b and precursors 221cx, 222cx, 231cx, and 232cx of conductive layers 221c, 222c, 231c, and 232c are formed by performing development of the black photosensitive film bx. It does not mean that alignment marks 51 will remain without fail on glass substrate 21 after the development. However, since alignment marks 51 are exposed through position determining holes of the second exposure mask 42 when a second exposure is performed with second exposing mask 42, alignment marks 51 normally remain on glass substrate 21.

Next, as shown in Fig. 3F, bus electrodes 221, 222, 231, and 232 are formed by firing glass substrate 21 on which the precursors 221bx, 222bx, 231bx, and 232bx of black layers 221b, 222b, 231b, and 232b and the precursors 221cx, 222cx, 231cx, and 232cx of conductive layers 221c, 222c, 231c, and 232c are formed. The peak temperature of calcinations is preferably 550 to 600°C. In the embodiment, it is 580°C. The thickness of bus electrodes 221, 222, 231, and 232 is preferably 1 to 6 µm. In the embodiment, it is 4 µm.

"Precursor" in the invention means a material obtained by heating a structure member paste in the state in which the structure member paste such as the black photosensitive paste is coated and then the organic component therein is removed, leaving the inorganic component which is not melted.

### Fifth step

In a fifth step, as shown in Fig. 3G, the dielectric paste is coated on glass substrate 21 on which bus electrodes 221, 222, 231, and 232 are formed by a screen printing method or a die coater method, and dried to form the precursors of dielectric layers 26 (not shown). After that, dielectric layers 26 having a thickness of 20 to 50 µm are formed by firing the precursors (not shown) of dielectric layers 26. In the embodiment, dielectric layers 26 having a thickness of about 40 µm are formed by firing the precursors (not shown) of the dielectric layers 26 at 590°C.

Next, as shown in Fig. 3H, protective layer 27 whose main component is manganese oxide is formed on dielectric layer 26 by a known technique such as a vacuum deposition method.

In the above way, front panel 20 is completed.

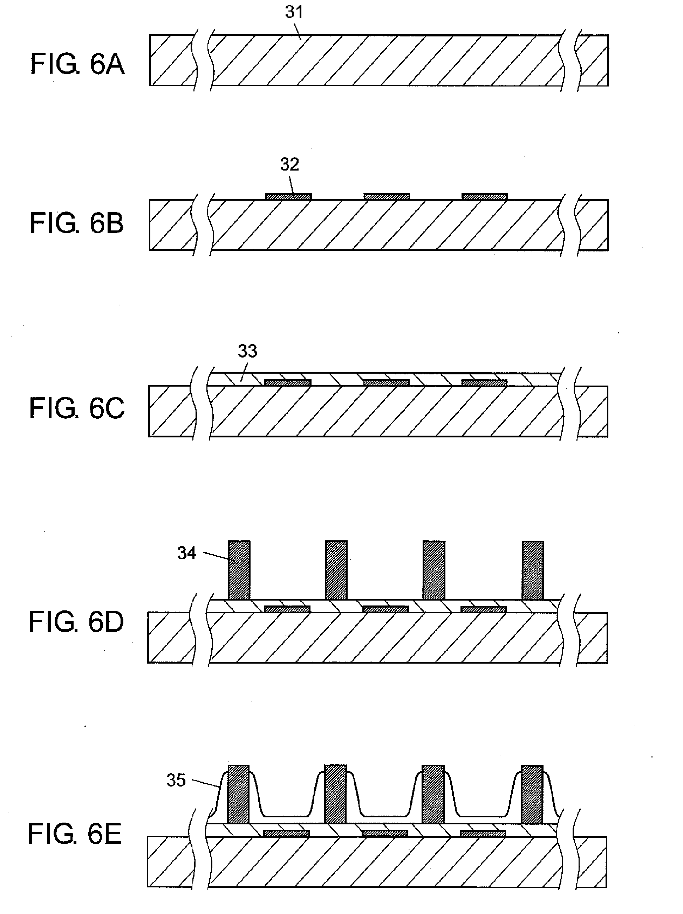

Next, the manufacturing method of back panel 30 is described. Figs. 6A, 6B, 6C, 6D, and 6E are views for explaining the manufacturing method of back panel 30 of PDP 10 in the first embodiment of the invention.

As shown in Fig. 6A, glass substrate 31 on the back surface side is cleaned with an alkali.

Next, as shown in Fig. 6B, a conductive photoconductive paste whose main component is silver is formed on glass substrate 31 in a stripe form at regular intervals by a screen printing method or a photolithography method, and precursors (not shown) of data electrodes 32 are formed. Next, data electrodes 32 are formed by firing glass substrate 31 on which the precursors (not shown) of data electrodes 32 are formed. A thickness of data electrodes 32 is, for example, 2 to 10 µm. In the embodiment, it is 3 µm.

Subsequently, as shown in Fig. 6C, a dielectric paste is coated on glass substrate 31 on which data electrodes 32 are formed, and is then fired, forming the dielectric layers 33. A thickness of dielectric layers 33 is, for example, 5 to 15µm. In the embodiment, it is 10 µm.

Subsequently, as shown in Fig. 6D, a photosensitive dielectric paste is coated on glass substrate 31 on which dielectric layers 33 are formed, and then fired, forming precursors (not shown) of barrier ribs 34. After that, it is exposed with an exposing mask, and then developed, forming barrier ribs 34. A height of barrier ribs 34 formed in the above way is, for example 100 to 150 µm. In the embodiment, it is 120 µm.

As shown in Fig. 6E, a phosphor ink containing any of a red phosphor, a green phosphor, and a blue phosphor is formed on the wall surface of barrier ribs 34 and the surface of dielectric layers 33. After that, drying and firing are performed, forming phosphor layers 35.

As the red phosphor, for example, (Y, Gd)BO₃:Eu or (Y, V)PO₄:Eu, or the like can be used. As the green phosphor, Zn₂SiO₄:Mn, (Y, Gd)BO₃:Tb, (Y, Gd)Al₃(BO₃)₄:Tb can be used. As the blue phosphor, for example, BaMgAl₁₀O₁₇:Eu or Sr₃MgSi₂O₈:Eu can be used.

In the above way, back panel 30 is completed.

Front panel 20 and back panel 30 are placed to face each other such that display electrode pairs 24 and data electrodes 32 grade-separated cross each other, and are sealed to each other with low melting point glass at a position outside the image displaying region in which discharge cells are formed. After that, a discharge gas containing xenon is charged into and sealed in the discharge space, completing PDP 10.

As described above, the embodiment includes a first step of forming the black photosensitive film bx on glass substrate 21, a second step of forming alignment marks 51 by exposing the black photosensitive film bx, and a third step of detecting the position of glass substrate 21 by recognizing alignment marks 51 in the undeveloped state of the black photosensitive film bx.

With the method, it is possible to form the alignment marks having high precision and good visibility in a simple manner without modification of a manufacturing line or a significant increase of man hours, and to manufacture the PDP with high productivity at low cost.

Further, it is possible to simultaneously form alignment marks 51 with the first exposure in a way of only changing the pattern of first exposing mask 41 used in formation of display electrode pairs 24. Accordingly, it is possible to manufacture the PDP at low cost without the use of an additional exposing mask.

### Embodiment 2

A structure of a PDP according to embodiment 2 is the same as the structure shown in Figs. 1, 2A and 2B. The various kinds of pastes used are also the same as in embodiment 1. Embodiment 2 is different from embodiment 1 in the point that exposure for forming alignment marks is performed after coating and drying a black photosensitive paste on a glass substrate 21 and then a conductive photosensitive paste is applied.

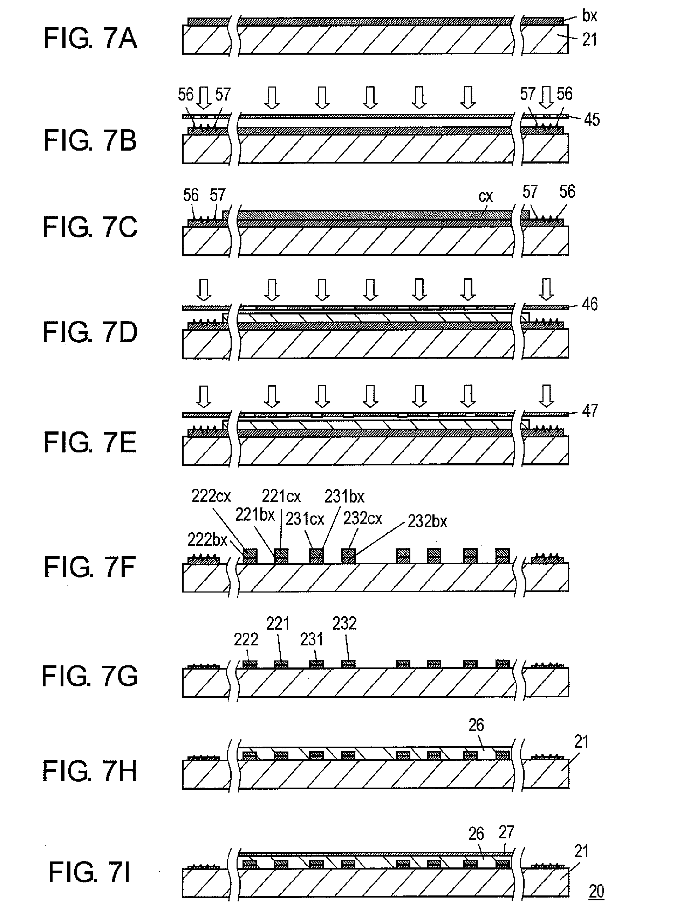

Figs. 7A, 7B, 7C, 7D, 7E, 7F, 7G, 7H, and 7T are views for explaining a manufacturing method of front panel 20 of PDP 10 according to embodiment 2. The manufacturing processing of front panel 20 is divided into 5 steps and each of the steps is described in detail below.

### First step

In a first step, a black photosensitive paste is applied and dried on glass substrate 21 of the front panel side, forming a black photosensitive film bx serving as a first photosensitive film.

Glass substrate 21 is cleaned with an alkali. Next, as shown in Fig. 7A, the black photosensitive film bx is formed on glass substrate 21. The black photosensitive film bx is formed by coating and drying a black photosensitive paste on the entire surface of glass substrate 21 by a known technique such as a screen printing method.

In this instance, the black photosensitive paste is applied at a region of glass substrate 21 at which display electrode pairs 24 are not supposed to be formed but the alignment marks are supposed to be formed. In the embodiment, the region corresponds to four corner areas of glass substrate 21. This point is the same as embodiment 1.

### Second step

In a second step, as shown in Fig. 7B, at least a first alignment mark and a second alignment mark are formed by exposing the black photosensitive film bx.

In detail, an exposure for forming first alignment mark 56 and second alignment mark 57 is performed using a first exposing mask 45 which is an exclusive exposing mask only for the alignment marks. In this instance, two alignment marks 56 and 57 are formed for every corner position of glass substrate 21 when forming the electrodes in consideration of a second exposure. First alignment mark 56 and second alignment mark 57 formed in the above way appear in the form of protrusions on the black photosensitive film bx. An exposure intensity of this instance is, for example, 300 mJ/cm².

Next, as shown in Fig. 7C, a conductive photosensitive film cx serving as a second photosensitive film is formed at a region on the black photosensitive film bx, at which the first alignment mark and the second alignment marks are not formed. The conductive photosensitive film cx is formed by coating and drying the above described conductive photosensitive paste on the black photosensitive film bx of glass substrate 21 by a known technique such as a screen printing method. In this instance, the conductive photosensitive paste is not applied at the region at which the alignment marks are formed.

As described above, the convexity and concavity on the surface of the black photosensitive film bx is relatively small at the time right after the exposure of the alignment marks and a certain period of time must pass before they can be used as the alignment marks. However, in embodiment 2, since glass substrate 21 is dried when forming the conductive photosensitive film cx after performing an exposure for forming the alignment marks, the alignment marks can be formed in a short time.

### Third Step

In a third step, as shown in Fig. 7D, second exposing mask 46 is aligned by recognizing first alignment mark 56, and a first exposure for forming scan electrodes 22 and sustain electrodes 23 is performed. In detail, position determination of second exposing mask 46 is performed by irradiating first alignment mark 56 formed on the surface of the black photosensitive film bx with light and taking a picture of first alignment mark 56 with a camera. In this instance, a coaxial epi-illumination is preferably used. Ssecond exposing mask 46 is provided with a pattern for forming bus electrodes 221, 222, 231, and 232. In this instance, the exposure intensity is, for example, 200 mJ/cm².

Next, as shown in Fig. 7E, a third exposing mask 47 is aligned by recognizing second alignment mark 57, and then a second exposure for forming scan electrodes 22 and sustain electrodes 23 is performed. In detail, a picture of second alignment mark 57 formed on the surface of the black photosensitive film bx is taken with a camera, and position determination of third exposing mask 47 is performed. At this time, the coaxial epi-illumination is also preferably used. Third exposing mask 47 is provided with a pattern for bus electrodes 221, 222, 231, and 232. However, the pattern provided in third exposing mask 47 is designed to have a slightly smaller width than that of second exposing mask 46. The exposure intensity of this instance is, for example, 200 mJ/cm².

### Fourth step

In a fourth step, as shown in Fig. 7F, precursors 221bx, 222bx, 231bx, and 232bx of black layers 221b, 222b, 231b, and 232b and precursors 221cx, 222cx, 231cx, and 232cx of conductive layers 221c, 222c, 231c, and 232c are formed by performing development processing.

Next, as shown in Fig. 7G, bus electrodes 221, 222, 231, and 232 are formed by firing glass substrate 21 on which the precursors 221bx, 222bx, 231bx, and 232bx of black layers 221b, 222b, 231b, and 232b and the precursors 221cx, 222cx, 231cx, and 232cx of conductive layers 221c, 222c, 231c, and 232c are formed.

### Fifth step

In a fifth step, as shown in Fig. 7H, a dielectric paste is applied on glass substrate 21 on which bus electrodes 221, 222, 231, and 232 are formed and dried by a known technique such as a screen printing method or a die coater method, forming the precursors (not shown) of dielectric layers 26. Then, dielectric layer 26 having a thickness of 20 to 50 µm is formed by firing the precursor (not shown) of dielectric layer 26.

Next, as shown in Fig. 7I, a protective layer 27 whose main component is magnesia oxide is formed on dielectric layer 26 by a known technique such as a vacuum deposition method.

Subsequently, front panel 20 and back panel 30 prepared in the same manner as in embodiment 1 are placed to face each other such that display electrode pairs 24 and data electrodes 32 grade-separated cross each other, and are sealed to each other with low melting point glass at a position outside the image displaying region in which discharge cells are formed. After that, a discharge gas containing xenon is charged into the discharge space and sealed therein, and PDP 10 is completed.

As described above, in embodiment 2, the number of steps for forming first alignment mark 56 and second alignment mark 57 is increased. However, this method has an advantage of being capable of performing an exposure without additionally providing a leaving time. The manufacturing method of embodiment 2 is especially advantageous in the case of manufacturing the PDP in which a black stripe is provided between neighboring display electrode pairs 24. By incorporating a pattern of the alignment marks into the exposing mask used for forming the black stripe, it is possible to simultaneously perform an exposing for the black stripe and form the alignment marks. Accordingly, it is possible to manufacture the PDP without the increase of man hours.

In embodiment 1 or embodiment 2 of the invention, as shown in Figs 2A and 2B, scan electrode 22 is composed of bus electrode 221 and bus electrode 222. Sustain electrode 23 is also composed of bus electrode 231 and bus electrode 232. However, the invention is not limited to this structure.

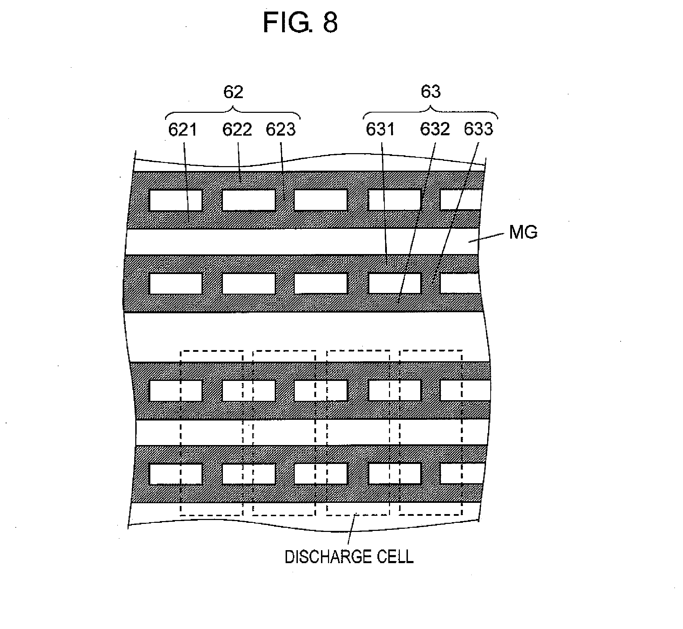

Fig. 8 is a view showing details of a different form of the display electrode pair of the PDP manufactured according to embodiment 1 or embodiment 2 of the invention. Scan electrode 62 includes bus electrode 621 corresponding to either one of long vertical timbers of a ladder and defining a discharge gap MG, bus electrode 622 corresponding to the other long vertical timber of the ladder and provided for enhancing a conductive characteristic of scan electrode 62, and bus electrode 623 corresponding to a lateral bar of the ladder and provided for decreasing resistance between bus electrode 621 and bus electrode 622. Sustain electrode 63 also includes bus electrode 631 corresponding to either one of long vertical timbers of a ladder and defining a discharge gap MG, bus electrode 632 corresponding to the other long vertical timber of the ladder and provided for enhancing a conductive characteristic of sustain electrode 63, and bus electrode 633 corresponding to a lateral bar of the ladder and provided for decreasing resistance between bus electrode 631 and bus electrode 632.

By structuring scan electrode 62 and sustain electrode 63 in such a form, it is possible to decrease the resistance between bus electrode 621 and bus electrode 622 and the resistance between bus electrode 631 and bus electrode 632 and also generate a more stable discharge. Fig. 8 shows an example in which bus electrodes 623 and 633 are provided for every discharge cell. However, bus electrodes 623 and 633 may be suitably provided according to needs, for example, provided for every three discharge cells.

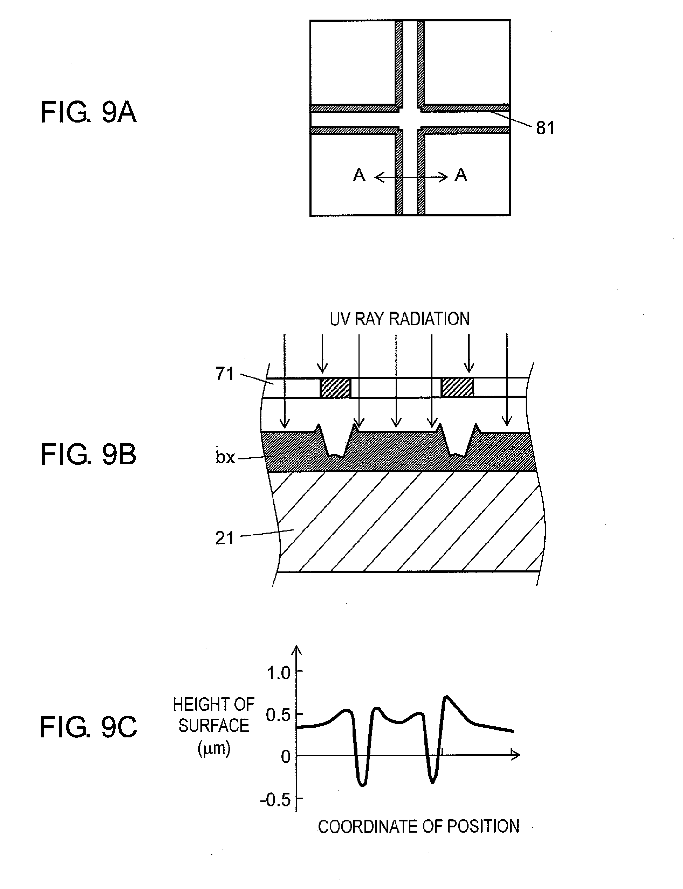

Figs. 9A, 9B, and 9C are views showing details of an alignment mark 81 having a different form from that of embodiment 1 or embodiment 2 of the invention. Fig. 9A is a schematic view of an image of alignment mark 81 taken by a camera. Fig. 9B is a view showing a relationship between first exposing mask 71 and alignment mark 81 of glass substrate 21. Fig. 9C is a view showing the result when the surface profile according to line A-A in Fig. 9A is measured by a surface roughness meter. A special feature of alignment mark 81 is that an unexposed portion has a cross-like contour. As shown in Fig. 9B, if the exposure is performed with first exposing mask 71 in which the unexposed portion has a cross-like contour, as shown in Fig. 9C, a convex portion having a cross-like contour and formed deep is formed. Accordingly, when a picture of alignment mark 81 is taken by a camera, it is possible to acquire an image of vivid alignment mark 81. Especially when alignment mark 81 is irradiated with a linear light beam using a coaxial epi-illumination, the light beam is not normally reflected at an inclined portion such as side walls of alignment mark 81. Accordingly, the contrasting density of the reflected light becomes vivid, and it becomes easy to recognize alignment mark 81.

In embodiment 1 and embodiment 2 of the invention, manufacturing methods of the PDP in which one front panel 20 and one back panel 30 are manufactured for one PDP by using the glass substrate having a size corresponding to one PDP are exemplified, but the invention is not limited thereto. For example, a plurality of front panels 20 and a plurality of back panels 30 may be manufactured at the same time by using a glass substrate having a size corresponding to plural PDPs, for example, 4 or 6 PDPs. That is, the invention can be applied to a so-called multiple-sheet manufacturing method.

Specific values used in embodiment 1 and embodiment 2 are only exemplarily provided, so those may be appropriately set to the optimum values according to specification of the PDPs.

### INDUSTRIAL APPLICABILITY

According to the manufacturing method of the flat panel display of the invention, it is possible to form the alignment mark having high precision and good visibility in a simple manner without modification of a manufacturing line or a great increase of man hours, and the invention is useful as a manufacturing method of a flat panel display such as a plasma display panel. That is, the invention is useful.

### DESCRIPTION OF REFERENCE SIGNS

10: PDP
20: FRONT PANEL
21: GLASS SUBSTRATE (ON FRONT SIDE)
22, 62: SCAN ELECTRODE
23, 63: SUSTAIN ELECTRODE
24: DISPLAY ELECTRODE PAIR
26: DIELECTRIC LAYER
27: PROTECTIVE LAYER
30: BACK PANEL
31: GLASS SUBSTRATE (ON BACK SIDE)
32: DATA ELECTRODE
33: DIELECTRIC LAYER
34: BARRIER RIB
35: PHOSPHOR LAYER
41, 45, 71: (FIRST) EXPOSING MASK
42, 46: (SECOND) EXPOSING MASK
47: THIRD EXPOSING MASK
51, 56, 57, 81: ALIGNMENT MARK
221, 222, 231, 232, 621, 622, 623, 631, 632, 633: BUS ELECTRODE
221b, 222b, 231b, 232b: BLACK LAYER
221bx, 222bx, 231bx, 232bx: PRECURSORS OF BLACK LAYERS
221c, 222c, 231c, 232c: CONDUCTIVE LAYERS
221cx, 222cx, 231cx, 232cx: PRECURSORS OF CONDUCTIVE LAYERS
bx: BLACK PHOTOSENSITIVE FILM
cx: CONDUCTIVE PHOTOSENSITIVE FILM
MG: DISCHARGE GAP

## Claims

1. A manufacturing method of a flat panel display, comprising:
a step of forming a photosensitive film on a substrate;
a step of forming an alignment mark by exposing the photosensitive film; and
a step of detecting a position of the substrate by recognizing the alignment mark in an undeveloped state of the photosensitive film.

2. The manufacturing method of claim 1, further comprising a step of drying the substrate between the step of forming the alignment mark and the step of detecting the position of the substrate.

3. The manufacturing method of claim 1, wherein the alignment mark is a concave portion or a convex portion.

4. The manufacturing method of claim 3, wherein amplitude of a step difference in levels of the concave portion and the convex portion is 0.5 µm or more.

5. The manufacturing method of claim 1, wherein the step of detecting the position of the substrate by recognizing the alignment mark in the undeveloped state of the photosensitive film includes a step of recognizing the alignment mark by irradiating the alignment mark with a linear light beam using a coaxial epi-illumination and recognizing a contrasting density of a reflected light beam.

6. The manufacturing method of claim 1, wherein the step of forming the photosensitive film includes a step of coating a photosensitive paste containing glass powder having an average particle size of 0.3 µm or larger and 1 µm or smaller, a photosensitive polymer, a photosensitive monomer, and a photo polymerization initiator on the substrate.

7. The manufacturing method of claim 1, wherein the step of forming the photosensitive film includes a step of coating a photosensitive paste containing 5% by weight or more and 40% by weight or less of a solid component, glass powder, a photosensitive polymer, a photosensitive monomer, and a photo polymerization initiator on the substrate.

8. A manufacturing method of a flat panel display, comprising:
a step of forming a first photosensitive film on a glass substrate;
a step of forming a second photosensitive film at a region at which an alignment mark of the first photosensitive film is not supposed to be formed;
a step of forming the alignment mark by exposing the first photosensitive film with a first exposing mask;
a step of detecting a position of the glass substrate by recognizing the alignment mark;
a step of position-aligning the glass substrate with a second exposing mask;
a step of exposing the second photosensitive film by using the second exposing mask;
a step of developing the first and second photosensitive films.

9. The manufacturing method of claim 8, further comprising a step of drying the glass substrate between the step of forming the alignment mark and the step of detecting a position of the glass substrate.

10. A manufacturing method of a flat panel display, comprising:
a step of forming a first photosensitive film on a glass substrate;
a step of forming a first alignment mark and a second alignment mark by exposing the first photosensitive film by using a first exposing mask;
a step of forming a second photosensitive film at a region at which the first alignment mark and the second alignment mark are not formed;
a step of detecting a position of the glass substrate by recognizing the first alignment mark;
a step of position-aligning the glass substrate with a second exposing mask;
a step of exposing the second photosensitive film by using the second exposing mask;
a step of detecting a position of the glass substrate by recognizing the second alignment mark;
a step of position-aligning the glass substrate with a third exposing mask;
a step of exposing the second photosensitive film by using the third exposing mask; and
a step of developing the first photosensitive film and the second photosensitive film.
